Europäisches Patentamt

European Patent Office

Office européen des brevets

(11) Publication number: **0 274 828**
**A1**

## EUROPEAN PATENT APPLICATION

(21) Application number: **87310116.6**

(22) Date of filing: **17.11.87**

(51) Int. Cl.⁴ **G11C 11/34**

(30) Priority: **18.11.86 GB 8627488**

(43) Date of publication of application:
**20.07.88 Bulletin 88/29**

(84) Designated Contracting States:
**BE CH DE ES FR GB IT LI NL SE**

(71) Applicant: **The British Petroleum Company p.l.c.**
**Britannic House Moor Lane**
**London EC2Y 9BU(GB)**

(72) Inventor: **Denyer, Peter Brian**
**91 Colinton Road**
**Edinburgh, EH9 3JL Scotland(GB)**
Inventor: **Sabine, Keth Allen**
**2 Nightingale Road**
**Hanwell London W7 1DG(GB)**

(74) Representative: **Ryan, Edward Terrence et al**
**BP INTERNATIONAL LIMITED, Patents Division Chertsey Road**
**Sunbury-on-Thames Middlesex, TW16 7LN(GB)**

(54) **Memory matrix.**

㉗ An electrically programmable memory matrix comprises a plurality of memory cells of layered amorphous or microcrystalline semiconductor repeatably switchable between high and low conductance states by voltages of alternate polarity. For each cell there is a single row line and a pair of column lines. The matrix comprises write enable means and means for maintaining voltage difference between pairs of column lines below that sufficient to write to a cell in the absence of a write-enable signal.

Xerox Cooy Centre

EP 0 274 828 A1

## MEMORY MATRIX

The present invention relates to memory matrix structures formed from a plurality of individual memory devices.

It is well known to construct memory matrix structures from a large number of individual memory devices each of which can exist in one of two different states. The majority of memory devices currently commercially available as based on Field Effect Transistors (FETs). These may be used to make random access memories (RAM) or read-only memories (ROM). Floating Gate FETs have been used to make erasable programmable read-only memories (EPROMs). The information in such memories is retained even in the absence of power but they can be erased with UV light and then reprogrammed to contain different information. Such devices also form the basis of Electrically Erasable Programmable Read Only Memories (EEPROMs).

There have been proposals to make alternative EEPROMs by the use of materials or devices which can dexist in two distinct conductance states. Such devices remain in one or other of those states when relatively low voltages are applied but can be converted to the other state by the application of a sufficiently high voltage. Most importantly for the EEPROM application, the device states are non-volatile.

US 3 761 896 discloses a memory matrix which uses memory devices which can exist in two different conductance states in the absence of applied power. The arrangement shown in the patent has two Y lines and one X line for ech memory cell. The memory cells comprise a memory device, a fixed resistor and a bipolar transistor. However only one pair of X, Y lines has variable voltage applied to it during reading and writing and are thus true word and bit lines. The other lines are maintained at a fixed voltage and are concerned with the operation of the bipolar transistor required for reading the state of the memory cell.

There are a large number of patent specifications which disclose memory matrix structures using two terminal memory devices in which the memory device can exist in one of two states e.g. GB 1 295 453, US 3 480 843, US 3 571 809, US 3 629 863, US 3 876 985 and US 3 922 648. In all these structures there is only one bit line and one word line for each memory cell.

GB 1 085 572 discloses a memory matrix using non-volatile memory devices. This uses one bit and one word line for each cell. The cell comprises junction memory material which can be put in one of two states. Erasing is carried out by passing a high current simultaneously through for all the devices. There is no possibility of reading or writing a zero in any individual cell.

GB 1 124 814 discloses a memory matrix using individual memory devices which can exist in two different conductance states in the absence of applied power and which can be changed from conducting to non-conducting state by passing a current greater than a given current. The matrix has two pairs of X (or word) lines and two pairs of Y (or bit) lines for each cell. However each memory cell has only one bit line and one word line connected to it and the provision of two sets of word and bit lines is based on creating groups of four memory cells.

US 4 180 866 discloses a single memory cell using a material similar to those used in some of the US patent specifications mentioned above. The material can exist in one of two conductance states. However the conductance state of a memory devices is not read directly by a sense amplifier. Instead, the base/collector capacity of a bipolar transistor associated with each memory device is used to indicate the state of the memory cell. The memory material is specifically stated to be used in threshold mode not in memory mode. In threshold mode the material will have a high conductance when a sufficiently high voltage is applied but the conductance will revert to the low conductance state when the applied voltage is reduced below a certain limit or threshold. The reading of the cell discharges the transistor capacitance so the device is a volatile memory, not suitable for use as an EPPROM. The additional lines shown in one embodiment are required for a separate write operation. However the write operation is only the application of a voltage above a given threshold. There is no requirements for the application of voltage of different polarity.

Owen et al in IEE Proc., Vol, 129, PT 1, Solid State and Electron devices, No 2, April 1982, pages 51-54 disclose an electrically programmable non-volatile semiconductor memory device. This non-volatile memory device is derived from a layered structure containing p and n-type amorphous silicon. The initially formed structure is converted into a non-volatile memory device by the application of a sufficiently large forward bias voltage.

European published patent application EP 95 283 discloses a memory device comprising layers of i and p and/or n-type amorphous or microcrystalline semiconducting material which has been subjected to a voltage sufficiently large to cause the structure to be permanently modified. In the device of EP 95 283 no p and n layers are adjacent.

Both types of memory device use dopable amorphous or microcrystalline semiconductor. By using dopable amorphous or microcrystalline semiconductor they are distinguished from some of the prior disclosures of memory devices which use chalcogenide glasses which are not dopable. Both types of devices use layers of different conductivity type and both are converted from a non-memory state to a non-volatile memory state by the application of a sufficiently high electrical voltage to permanently modify the electrical characteristics of a device.

Non-volatile memory devices such as those mentioned above have at least two conductance states in the absence of an applied voltage. These states may be described as "high" and "low" corresponding to ON and OFF for the device.

These non-single crystal layered dopable semiconductor memory devices have the common characteristic that they are not electrically symmetrical. As a result, switching from one state to another is achieved by applying a voltage pulse of appropriate polarity, e.g. forward bias polarity to turn ON, reverse polarity to turn off. In contrast, chalcogenide glass memory devices are in general electrically symmetrical, such that the magnitude and shape of a voltage pulse applied across it will be significant, but not the polarity. The problem of making memory matrix structures from individual memory devices based on dopable amorphous semiconductor of the type described above is thus quite different from that faced with the prior devices based on chalcogenide glasses.

According to the present invention there is provided an electrically programmable memory matrix comprising a plurality of memory cells arranged in rows and columns, and row and column decoders connected to row and column lines for selecting an individual memory cell, characterised in that

1) the memory cell comprises

a) a memory device which is a layered amorphous or microcrystalline semiconductor structure which is repeatably switchable between high and low conductance states by voltages of alternate polarity, and,

(b) a memory cell FET having source, drain, and a gate, one terminal of the memory device being connected to the source or drain terminal of the FET,

2) a single row line for each row is connected to the gates of each memory cell FET in each row,

3) a first and second pair of column address lines is provided for each cell, and the terminals of the FET and memory device not connected with each other are connected between the pair of column address lines,

4) all of said first and second address lines are connected through addressing switches controlled by the column decoder to first and second nodes respectively,

5) write enable means having
a write-enable input, for receiving a write-enable signal,
a date-input for receiving data to be written to the matrix, means for

i) maintaining the voltage difference between the first and second nodes below that required to write to a memory device unless a write-enable signal is present on the write-enable input and for

ii) maintaining the voltage difference between the nodes at a value sufficient to write to the device in the presence of a write-enable signal on the write-enable line and

iii) for selecting the relative polarity of the nodes in accordance with data on the data input, and

6) a sensing means for sensing the conductance state of a selected memory cell, and producing an output in one of two logic states, the output being in one of such logic states when the selected cell is in a low conductance state and is in the other logic state when the cell is in a high conductance state.

As indicated above the memory matrix of the present invention is intended for use with memory devices having particular characteristics, namely the ability to be put into one conductance state by an electric voltage applied in one direction across the device and to be placed in a different conductance state by an electrical voltage applied in the reverse direction.

. Individual memory devices suitable for use in the present invention may be made in accordance with for example the IEE Proceedings reference and EP 95283 already mentioned. There is therefore no need to describe their preparation in detail.

These references disclose the transformation of the device from a state in which is does not have memory characteristics into a state which has memory characteristics by the application of a voltage which is higher than that required to produce subsequent switching. This process may be described as "forming". EP 162529 discloses a non-volatile memory device based on amorphous or microcrystalline semiconductor in which a defect layer is present. This reduces the forming voltage and the possibility of reducing the forming voltage to below the voltage required to switch the device between high and low conductance states is mentioned. Even in devices where an initial single conductance state cannot be detected it may be desirable to carry out an initial step of applying a controlled voltage in order to stabilise the subsequent behaviour of the device. Such a step is known to those skilled in the art as "contact conditioning".

Devices which have been electrically modified, whether by "forming" or by "contact conditioning" are particularly suitable for use in the present invention.

The amorphous or microcrystalline semiconductor is preferably silicon.

The memory matrix may be constructed from discrete memory devices and other circuit elements wired together. However in accordance with modern practice it is preferably constructed as an integrated circuit in which the memory devices are deposited on a semiconductor substrate in which the other circuits components required are also produced. The production of memory matrices in crystalline semi-conductor eg silicon is well known to those skilled in the art and need not be discussed here.

In addition to writing to the individual memory cells by applying voltages in different directions across the cell, it is necessary, in order to read the information stored in any given cell, to be able to determine the conductance state of the memory device in that cell.

EP 152689 discloses an optical method of reading the conductance state of a memory device. However in order to be as compatible with existing technology as possible it is desirable to determine the conductance state using purely electrical methods. Any such method must determine the conductance state without any risk of applying a voltage across the device sufficiently large to change its conductance state.

Memory devices suitable for use in memory matrices in accordance with the present invention may be made by applying a "forming" or "conditioning" voltage to a structure which does not have memory properties. Such "forming" or conditioning" steps are disclosed in IEE Proc., Vol 129, Pt 1, Solid State and Electron Devices No. 2, April 1982, pp 51-54 and in EP 95283.

It is convenient to provide the memory matrix with circuitry capable of carrying out such "forming". In a preferred form of the present invention there is also provided in the memory matrix a facility for applying a forming voltage to the cells.

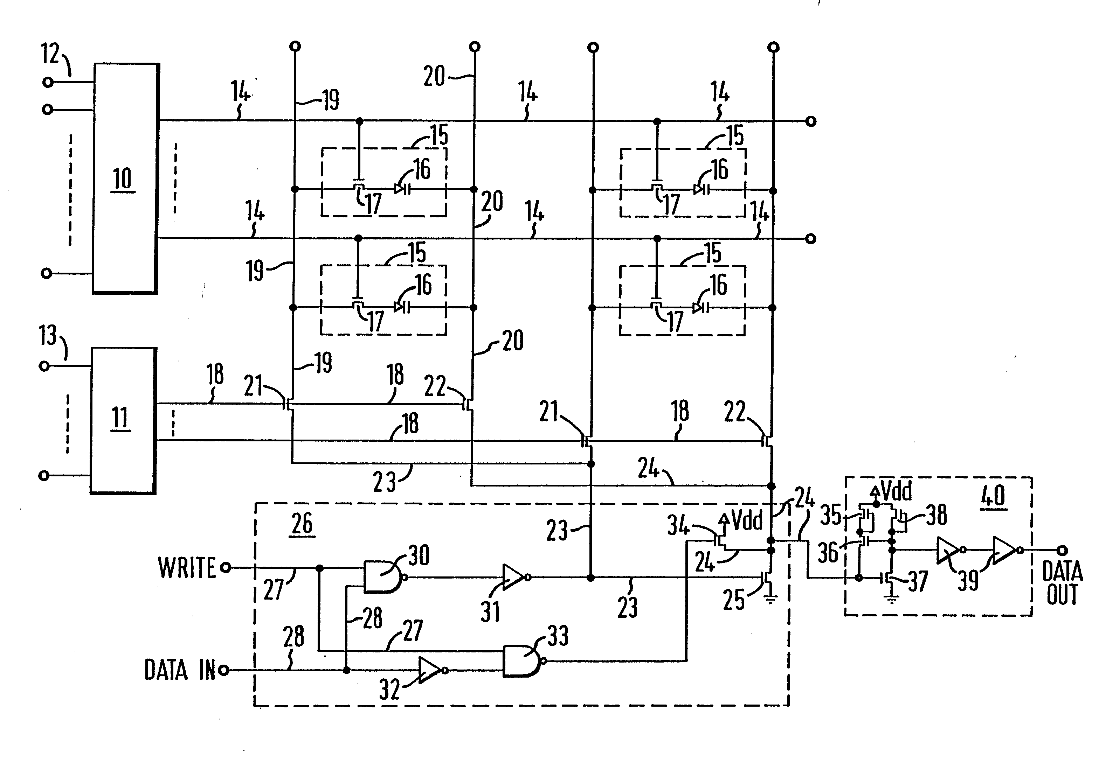

The invention will now be described with reference to the drawing which is a diagrammatic representation of a matrix according to the present invention.

The memory device used in the matrix is a device of the type described in EP 95283 having a structure comprising layers of p-, i-and n-type amorphous silicon. Layered p-i-n structures made as described in accordance with EP 95283 are converted into memory devices by the application of a sufficiently large forming reverse bias voltage i.e. with the n-layer at a positive potential relative to the p-type layer.

The other components used extensively in the matrix are MOSFETs Except where indicated otherwise these are n-channel devices.

The FETs are enhancement-mode devices which are normally off in the absence of a gate bias. Thus the devices will be off when the gate voltage and the source voltage are the same. In an n-channel device the source will be negative with respect to the drain and in a p-channel device the source will be positive with respect to the drain. If the gate is made more positive than the source for an n-channel device (or more negative than the source for a p-channel device), the FET will switch on when a threshold voltage is reached. In the specific embodiment the logic 0 corresponds to 0 volt and logic 1 to +5 volt, as is conventional in integrated circuit design.

The memory matrix as provided with a row decoder (10), a column decoder (11), both with a plurality of inputs indicated generally at (12) and (13) respectively. Row and column decoders are well known in memory matrix structures and will therefore not be described further. The row decoder has a plurality of bit (or X) lines 14. The matrix further comprises individual memory cells, indicated generally at (15) arranged in rows and columns. Each memory cell comprises an amorphous silicon memory device (16) and an n-channel MOSFET (17) which serves to isolate the memory device (16) except when a logic 1 signal is applied on the appropriate word (or X) line 14.

The symbol used for the memory cell is not intended to indicate that the memory device has diode-like properties. However the p-player side of the device corresponds to the base of the triangle symbol (as in a p-n diode). The gate of FET (17) is held at logic 0 when no word addressing signal is present on line (14). FET (17) is then is a non-conducting state.

The column decoder (11) has a plurality of bit control lines (18), each corresponding to a different column of the memory matrix. Each memory cell is connected to two bit (or Y) lines (19) and (20). Each pair of bit lines 19 and 20 has a pair of FETs (21, 22), each connected with the source and drain in series with the respective bit line. The gates of each pair of each FETs (21) and (22) are connected to a common bit control line (18) of the column decoder (11).

All the word lines (19) are connected via FETs (21) to a common point which may be referred to as node (23). Similarly all the word lines (20) are connected to node (24) through FETs (22). FET (25) has its source and drain in series between node (24) and earth and its gate is connected to node (23). Logic 1 on the gate of FET (25) will switch on FET (25) so earthing node (24) and placing it at logic 0. Logic 0 at node (23) will isolate node (24) from earth by switching off FET (25). Node (24) will then be at whatever voltage is applied to it. This may be logic 1 in certain situations as described below.

The logic level of node (23), and thus of node (24), is controlled by the write-enable circuit indicated generally at (26). This circuit comprises a write-enable line (27) and a data-input line (28). The write-enable line (27) and the data-input line (28) are connected to a NAND gate (30). This is in turn connected to a NOT gate (inverter) (31). The output of inverter (31) is connected to node (23).

The data-input line (28) is connected to a NOT gate (32). The output from this gate and the write-enable line are connected to a NAND gate (33). The output from this gate is connected to the gate of a p-channel FET (34). The source and drain of FET (34) are connected in series between node (24) and supply voltage, Vdd.

The Truth Table for the write-enable circuit (26) is set out below.

| Write-Enable | Data-Input | Node 23 | FET 34 gate | Node 24 |
|---|---|---|---|---|
| 1 | 1 | 1 | 1 | 0 |
| 1 | 0 | 0 | 0 | 1 |
| 0 | 1 | 0 | 1 | 0 |
| 0 | 0 | 0 | 1 | 0 |

From the above Table it will be seen that if the write-enable and data-input lines are both at logic 1 then node (23) is at logic 1 as is the gate of FET (34). If node (23) is at logic 1 then the gate of FET (25) is also at logic 1 and node (24) is therefore earthed and at logic 0. If the gate of FET (34) is at logic 1 then as FET (34) is a p-channel FET it will be non-conducting and the supply voltage Vdd (+5 volts) will not be applied to node (24). The result will be that where FETs (21) and (22) are in a conducting state because the appropriate line (18) is at logic 1 then bit line (19) will be at logic 1 (+5 volts) and bit line (20) will be at logic 0. +5 volt voltage will then be applied to the memory device (16) in the cell where logic 1 has been applied to word line (14). The memory device (16) will then be switched into a conducting state, regardless of its previous condition. In this embodiment the conducting state is used to represent logic 1.

If the write-enable line is at logic 1 and the data-input line is at logic 0, then the truth table above shows that both node (23) and the gate of FET (34) will be at logic 0. If node (23) is at logic 0 then FET (25) will be switched off and node (24) will not be earthed. The p-channel FET (34) will be switched on and the supply voltage Vdd (+5 volts) will be applied to node (24). The result will be that the selected bit line (20) will be at +5 volts and the corresponding bit line (19) will be at 0 volts. The selected memory device (16) will then be subjected to a reverse bias voltage which will switch it ot the non-conducting condition, representing logic 0.

In any situation in which the write-enable line (27) is at logic 0 then regardless of the state of the data-input line both node (23) and the gate of FET (34) will be at logic 0 and logic 1 respectively so placing both nodes (23) and (24) at logic 0, thereby preventing any writing to any memory cell and isolating node (24) from the voltage applied at (34) which would otherwise short circuit through FET (25) giving an unnecessary consumption of power.

When the write-enable line is at logic 0, node (23) will also be at logic 0 and therefore node (24) will not be earthed through FET (25), and FET (34) will be in a non-conducting condition. Under these conditions the sense amplifier (40) is able to determine the state of a memory cell selected by appropriate logic levels on the word lines (14) and bit control lines (18).

A current source comprising p-channel FET (35) and FET (36) supplies current to node (24) and hence the cell (15). FET (37) senses the voltage across the cell resulting from this current, with p-channel FET (38) acting as load. Negative feedback is applied to the curent source by means of the connection of the drain of FET (37) to the gate of FET (36).

If the cell is in the on state, the voltage on node (24) falls thus turning off FET (37); however the negative feedback causes FET (36) to turn on more, holding node (24) close to the threshold voltage of FET (37). The drain of FET (37) rises to a logic 1 and this is buffered by inverters e.g. (39).

If the cell is in the off state, the voltage on node (24) rises and so FET (37) turns on. Again due to the negative feedback through the current source FET (36) the voltage on node (24) does not rise significantly above the threshold voltage of FET (37), and the drain voltage of FET (37) falls to approximately two threshold drops i.e. about 2 volts. This is below the input threshold voltage for the subsequent inverters (39) thus representing a logic low. Because node (24) is held by the negative feedback at a voltage close to the threshold voltage (about 1 volt), the risk of accidental or unintentional switching of the memory device when reading the state of that device is avoided.

An additional feature of the memory matrix described is the ability for a large voltage to be applied to the cell during what is known as the forming process, using the same addressing circuitry as used for reading and writing to the cell during subsequent operation.

This may be achieved by providing a means (not shown) for switching the voltage applied to the source of FET 34 between (1) a source of forming voltage (greater than the supply voltage) and (2) the supply voltage (typically +5 volts).

## Claims

1. An electrically programmable memory matrix comprising a plurality of memory cells arranged in rows and columns, and row and column decoders connected to row and column lines for selecting an individual memory cell, characterised in that

1) the memory cell comprises
(a) a memory device which is a layered amorphous or microcrystalline semiconductor structure which is repeatably switchable between high and low conductance states by voltages of alternate polarity, and.
(b) a memory cell FET having source, drain, and a gate, one terminal of the memory device being connected to the source or drain terminal of the FET,

2) a single row line for each row is connected to the gates of each memory cell FET in each row,

3) a first and second pair of column address lines is provided for each cell, and the terminals of the FET and memory device not connected with each other are connected between the pair of column address lines,

4) all of said first and second address lines are connected through addressing switches controlled by the column decoder to first and second nodes respectively,

5) write enable means having
a write-enable input, for receiving a write-enable signal,
a data-input for receiving data to be written to the matrix, means for
i) maintaining the voltage difference between the first and second nodes below that required to write to a memory device unless a write-enable signal is present on the write-enable input and for
ii) maintaining the voltage difference between the nodes at a value sufficient to write to the device in the presence of a write-enable signal on the write-enable line and
iii)for selecting the relative polarity of the nodes in accordance with data on the data input, and

6) a sensing means for sensing the conductance state of a selected memory cell, and producing an output in one of two logic states, the output being in one of such logic states when the selected cell is in a low conductane state and is in the other logic state when the cell is in a high conductance state.

2. A memory matrix according to claim 1 wherein the memory device is an electrically modified layered amorphous or microcrystalline structure.

3. A memory matrix according to claim 2 wherein the memory device has been electrically modified by the application of a voltage sufficiently large to transform it from an initial single conductance state to one having at least two conductance states.

4. A memory matrix according to any one of the preceding claims wherein the amorphous or microcrystalline semiconductor is silicon.

European Patent Office

EUROPEAN SEARCH REPORT

Application Number

EP 87 31 0116

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 037 243 (MOTOROLA)<br>* Column 3, line 28 - column 5, line 45; figures 6,7 *<br>--- | 1 | G 11 C 11/34 |
| A | US-A-4 237 472 (R.C.A. CORP.)<br>* Column 3, line 3 - column 5, line 17; figure 3 *<br>--- | 1 | |
| A | IBM TECHNICAL DISCLOSURE BULLETIN, vol. 14, no. 11, April 1972, pages 3551-3552, New York, US; R.F. BROOM: "Bistable nonvolatile memory cell using vanadium dioxide"<br>* Whole article *<br>----- | 1 | |

| | | | TECHNICAL FIELDS SEARCHED (Int. Cl.4) |
|---|---|---|---|
| | | | G 11 C 11/34<br>G 11 C 17/00 |

The present search report has been drawn up for all claims

| Place of search | Date of completion of the search | Examiner |
|---|---|---|
| THE HAGUE | 18-04-1988 | DEGRAEVE L.W.G. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P0401)